# EUROPEAN PATENT APPLICATION

(11) **EP 4 071 697 A1**
(43) Date of publication of application: **12.10.2022**
(21) Application number: 20894995.8
(22) Date of filing: 27.11.2020
(51) Int. Cl.: G06Q 50/08, G06F 30/10, G06F 30/13

(54) **DATA MANAGEMENT SYSTEM, MANAGEMENT METHOD, AND MANAGEMENT PROGRAM**

(30) Priority: 03.12.2019 JP 2019218514
(71) Applicant: TOPCON CORPORATION, Tokyo 174-8580 (JP)
(72) Inventor: DOJI Atsushi, Tokyo 174-8580 (JP); YAMADA Toshio, Tokyo 174-8580 (JP); NISHITA Nobuyuki, Tokyo 174-8580 (JP); YANOBE Satoshi, Tokyo 174-8580 (JP); KANEKO Junki, Tokyo 174-8580 (JP)
(74) Representative: dompatent von Kreisler Selting Werner - Partnerschaft von Patent- und Rechtsanwälten mbB
(86) International application number: PCT/JP2020/044194
(87) International publication number: WO 2021/111999

(57) **Abstract**

Data management to reflect an actual construction status in design is realized. In order to achieve the object, a management system includes a design database (3) recording, with respect to members of a construction object, design data of at least member IDs, member coordinates, member shapes, a measurement database (4) recording measurement data of the construction object, a starting point member selecting unit (5) configured to select a starting point member from the design database, a measurement information selecting unit (6) configured to select the measurement data corresponding to the starting point member from the measurement database, and an actual status model creating unit (7) configured to create an actual status model with respect to the starting point member by performing shape correction of a design model of the starting point member created from the design database by using the measurement data.

## Description

### Technical Field

The present invention relates to a system, method, and program for managing data for design and construction of a construction object.

### Background Art

In recent years, in the field of construction, utilization of a 3D model called BIM (Building Information Modeling) has been promoted. BIM has been increasingly utilized at design sites, that is, planning, architectural design, facility design, design analysis, execution design, construction planning, and component manufacturing. For example, Patent Literature 1 discloses a technology for utilizing BIM at manufacturing sites of members at a plant.

### Citation List

### Patent Literature

Patent Literature 1: Japanese Published Unexamined Patent Application No. 2019-21190

### Summary of Invention

### Technical Problem

However, at construction sites, utilization of BIM has been delayed, and a construction drawing is separately created based on design BIM created at a design site, and construction is performed based on the construction drawing. The construction drawing is created in each process, however, there is no system for reflecting an actual construction status in the upstream design BIM, so that a problem frequently occurs in which a construction drawing for the next process is created based on old BIM information, and an on-site construction status does not match the construction drawing. Therefore, data management to reflect the construction status in the upstream drawing and turning over the construction status to the next construction process has been desired.

The present invention was made in view of this problem, and an object thereof is to realize data management that reflects an actual construction status in design. Solution to Problem

In order to solve the problem described above, a management method according to an aspect of the present invention includes, by transmitting and receiving information to and from a design database recording, with respect to members of a construction object, design data of at least member IDs, member coordinates, and member shapes, and a measurement database recording measurement data of the construction object, a step of selecting a starting point member from the design database, a step of selecting the measurement data corresponding to the starting point member from the measurement database, and a step of creating, with respect to the starting point member, an actual status model by performing shape correction of a design model of the starting point member created from the design database by using the measurement data.

In the aspect described above, it is also preferable that the management method further includes a step of recording the starting point member as a design correction member, and coordinates and a shape of the actual status model of the starting point member as design correction member coordinates and a design correction member shape in a design correction database.

In the aspect described above, it is also preferable that the management method further includes a step of selecting an adjacent member adjacent to the starting point member from the design database, a step of creating a design corrected model by performing shape correction of a design model of the adj acent member in accordance with a shape of the actual status model of the starting point member, and a step of recording coordinates and a shape of the design corrected model of the adjacent member as design correction member coordinates and a design correction member shape in a design correction database.

In the aspect described above, it is also preferable that the management method further includes a step (A) of selecting, by defining the adjacent member as a first adjacent member, a second adjacent member adjacent to the first adjacent member from the design database, a step (B) of creating a design corrected model by performing shape correction of a design model of the second adjacent member in accordance with the shape of the design corrected model of the first adjacent member, a step (C) of recording coordinates and a shape of the design corrected model of the second adjacent member as design correction member coordinates and a design correction member shape in the design correction database, and a step (D) of creating and recording design corrected models of a third adjacent member, a fourth adjacent member, ..., and an n-th adjacent member by repeating the steps (A) to (C) according to a request of an administrator.

In the aspect described above, it is also preferable that, with respect to the starting point member, the design model and the actual status model are compared, and when the design and the actual status are different from each other, the step of selecting the adjacent member is started.

In the aspect described above, it is also preferable that the management method further includes a step of writing the design correction member coordinates and the design correction member shape of the design correction member recorded in the design correction database over member coordinates and a member shape linked by the member ID in the design database.

It is also preferable that the management method described above is described as a computer program and enabled for execution.

In addition, in order to solve the problem described above, a management system according to an aspect of the present invention includes a design database recording, with respect to members of a construction object, design data of at least member IDs, member coordinates, and member shapes, a measurement database recording measurement data of the construction object, a starting point member selecting unit configured to select a starting point member from the design database, a measurement information selecting unit configured to select the measurement data corresponding to the starting point member from the measurement database, and an actual status model creating unit configured to create an actual status model with respect to the starting point member by performing shape correction of a design model of the starting point member created from the design database by using the measurement data.

In the aspect described above, it is also preferable that the management system further includes a design corrected model creating unit configured to record the starting point member as a design correction member, and coordinates and a shape of the actual status model of the starting point member as design correction member coordinates and a design correction member shape in a design correction database.

In the aspect described above, it is also preferable that the management system further includes an adjacent member selecting unit configured to select an adj acent member adj acent to the starting point member from the design database, and a design corrected model creating unit configured to create a design corrected model by performing shape correction of a design model of the adjacent member in accordance with a shape of the actual status model of the starting point member, and record coordinates and a shape of the design corrected model of the adjacent member as design correction member coordinates and a design correction member shape in a design correction database.

In the aspect described above, it is also preferable that the management system further includes a design corrected model recursive creating unit configured to select, by defining the adjacent member as a first adjacent member, a second adjacent member adjacent to the first adjacent member from the design database, create a design corrected model by performing shape correction of a design model of the second adj acent member in accordance with the shape of the design corrected model of the first adjacent member, record coordinates and a shape of the design corrected model of the second adjacent member as design correction member coordinates and a design correction member shape in the design correction database, and repeatedly create and record design corrected models of a third adjacent member, a fourth adj acent member, ..., and an n-th adj acent member according to a request of an administrator.

In the aspect described above, it is also preferable that the management system further includes a model comparing unit configured to compare the design model and the actual status model with respect to the starting point member, and when the model comparing unit determines that the design and the actual status are different from each other, the adjacent member selecting unit functions.

In the aspect described above, it is also preferable that the management system includes a design correction reflecting unit configured to write design correction member coordinates and a design correction member shape of the design correction member recorded in the design correction database over member coordinates and a member shape linked by the member ID in the design database.

### Advantageous Effects of Invention

According to the data management system, management method, and management program of the present invention, data management to reflect an actual construction status in design can be realized.

### Brief Description of Drawings

Fig. 1 is a block diagram illustrating a configuration of a management system according to a first embodiment of the present invention.
Fig. 2 is a diagram illustrating an example of a design database according to the management system.
Fig. 3 is a diagram illustrating an example of a measurement database according to the management system.
Fig. 4 is a diagram illustrating an example of a design correction member database related to the management system.
Fig. 5 is a management flowchart illustrating a management method according to the first embodiment of the present invention.
Fig. 6 is a work image view of the management flow.
Fig. 7 is a configuration block diagram of a management system according to a second embodiment of the present invention.
Fig. 8 is a management flowchart illustrating a management method according to the second embodiment of the present invention.
Fig. 9 is a work image view of the same management flow.
Fig. 10 is a configuration block diagram of a management system according to a third embodiment of the present invention. A management flowchart illustrating a management method.
Fig. 11 is a management flowchart illustrating a management method according to the third embodiment of the present invention.
Fig. 12 is a work image view of the management flow.
Fig. 13 is a configuration block diagram of a management system according to a fourth embodiment of the present invention.
Fig. 14 is a management flowchart illustrating a management method according to the fourth embodiment of the present invention.
Fig. 15 is a configuration block diagram of a management system according to a fifth embodiment of the present invention. A management flowchart illustrating a management method.
Fig. 16 is a management flowchart illustrating a management method according to the fifth embodiment of the present invention.
Fig. 17 is a work image view of the management flow.

### Description of Embodiments

Next, preferred embodiments of the present invention will be described with reference to the drawings.

### <First Embodiment>

### (Configuration of Management System)

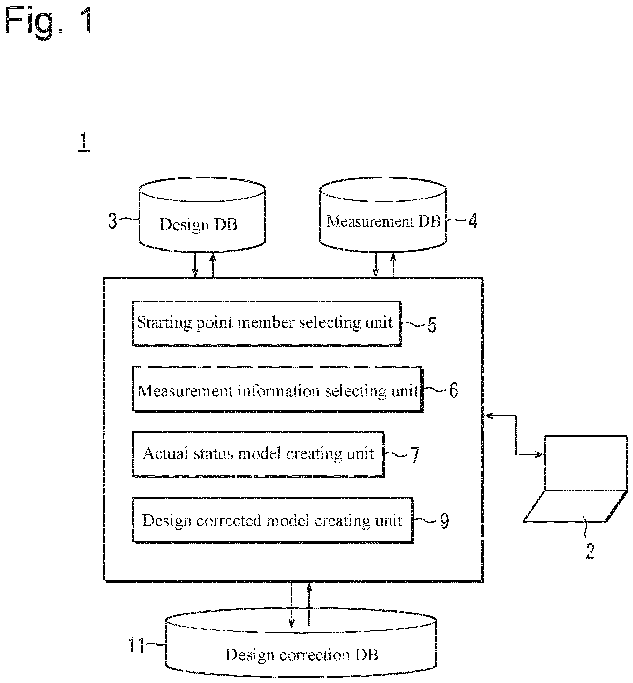

Fig. 1 is a configuration block diagram of a management system 1 according to a first embodiment of the present invention. The management system 1 includes an input/output device 2, a design database 3, a measurement database 4, a design correction database 11, a starting point member selecting unit 5, a measurement information selecting unit 6, an actual status model creating unit 7, and a design corrected model creating unit 9.

The input/output device 2 is a general-purpose personal computer, tablet terminal, etc., including at least a computing unit, a recording unit, a communication unit, a display unit, and an operation unit, and can be operated by an administrator.

The respective functional units of the starting point member selecting unit 5, the measurement information selecting unit 6, the actual status model creating unit 7, and the design corrected model creating unit 9 are configured by electronic circuits such as a CPU (Central Processing Unit), an ASIC (Application Specific Integrated Circuit), a PLD (Programmable Logic Device) such as an FPGA (Field Programmable Gate Array) . The respective functional units may be configured inside the input/output device 2 or by either separate external hardware/software. In the latter case, the respective functional units can transmit and receive information to and from the input/output device 2 through a network.

The design database 3 and the measurement database 4 are stored in a server computer with which communication can be made through a network. The server computer can communicate with related functional units, and can transmit and receive information to and from the related functional units.

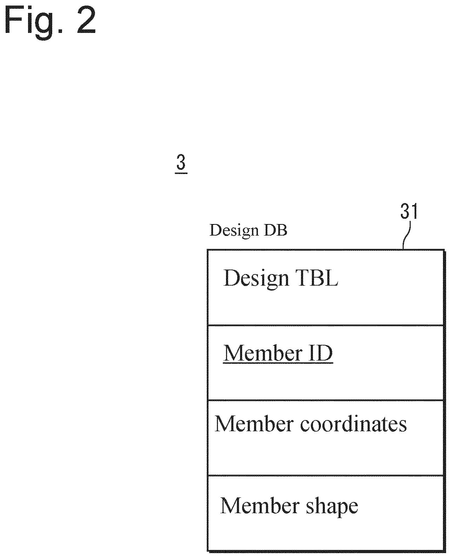

In the design database 3, design data based on design BIM (data on each construction member constituting the construction object in the form of 3D model, the 3D model includes shapes of surfaces, lines, and points. Hereinafter, also referred to as design model) of a construction object as a managing object is stored. The design database 3 stores a design table 31 in which, as illustrated in Fig. 2, with respect to a construction member, at least member identification information (hereinafter, member ID), member coordinates, and a member shape are associated with each other.

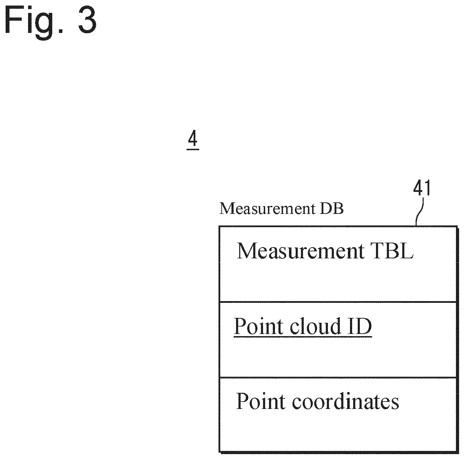

In the measurement database 4, measurement data (point cloud data in which coordinate information is registered, point data, screen data holding coordinate information of measurement spots, and data on construction errors of construction members) of the construction object described above obtained by using a scanner, etc., are stored. For the measurement data, point cloud identification information (hereinafter, point cloud ID) is provided with respect to each measurement. The measurement database 4 stores a measurement table 41 in which, as illustrated in Fig. 3, at least a point cloud ID and point coordinates are associated with each other.

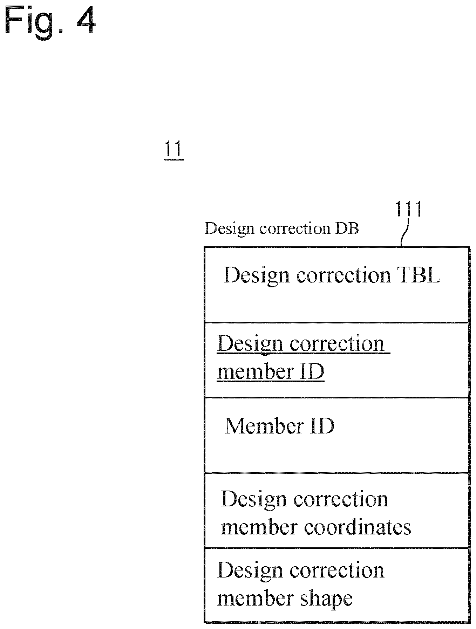

The design correction database 11 is stored in a server computer with which communication can be made through a network. In the design correction database 11, design correction data of each member that needs to be corrected in design (hereinafter, referred to as "design correction member") is recorded as needed. The design correction database 11 stores a design correction table 111 in which, as illustrated in Fig. 4, at least identification information of the design correction member (hereinafter, design correction member ID), coordinates of the design correction member, and a shape of the design correction member are associated with each other. Each design correction member is linked to the design database 3 by a member ID.

The starting point member selecting unit 5, the measurement information selecting unit 6, the actual status model creating unit 7, and the design corrected model creating unit 9 will be described in a management method according to the present embodiment to be described below.

### (Management Method)

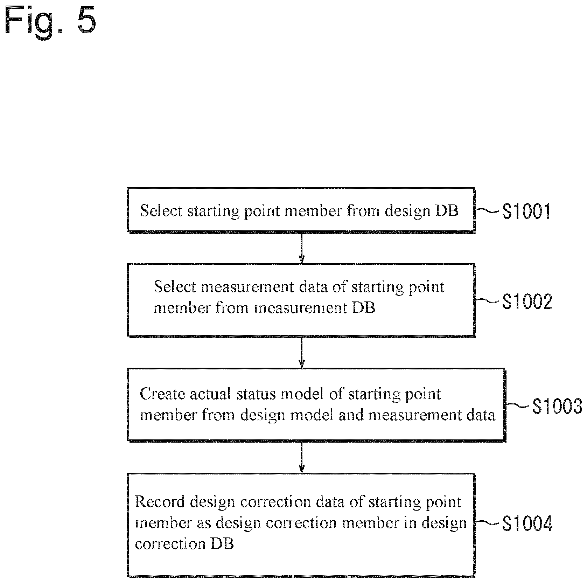

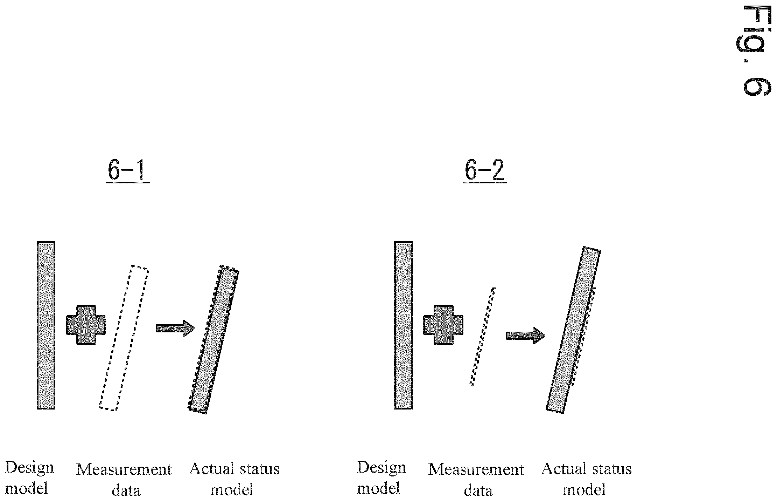

Fig. 5 is a management flowchart illustrating a management method according to the first embodiment of the present invention, and Fig. 6 is a work image view of the management flow. In the management method according to the present embodiment, with respect to a certain member, based on a design model and measurement data, an actual status model reflecting an actual construction is created, and such data management is performed.

When management processing is started, in Step S1001, the starting point member selecting unit 5 reads the design table 31, displays member IDs or design models on the input/output device 1, and causes an administrator to select a member that the administrator desires to manage ("starting point member"). The administrator selects a starting point member through the input/output device 2.

Next, the processing shifts to Step S1002, and the measurement information selecting unit 6 reads point coordinates in the measurement table 41, and extracts point cloud data substantially corresponding to member coordinates of the starting point member selected in Step S1001 or causes the administrator to select the point cloud data through the input/output device 2. At this time, not only a cloud of points whose coordinates completely match the member coordinates but also a cloud of points whose coordinates are within error values set in advance are extracted.

Next, the processing shifts to Step S1003, and the actual status model creating unit 7 calculates, with respect to the starting point member, a shape in an actual status of the starting point member based on the design model and measurement data (point cloud data) extracted in Step S1002, and creates an actual status model of the starting point member.

Here, creation of the actual status model by the actual status model creating unit 7 is performed, for example, as follows.
(Case 1) As indicated by the reference sign 6-1 in Fig. 6, when a shape of the starting point member is acquired from the measurement data, the shape of the design model is corrected to a shape based on the measurement data.
(Case 2) As indicated by the reference sign 6-2 in Fig. 6, when partial information on the shape of the starting point member (surfaces, lines, and points) is acquired from the measurement data, disposition coordinates, rotation, or inclination of the design model is corrected.
(Case 3) When construction error information on the shape of the starting point member is acquired, based on the construction error information, the shape, disposition coordinates, rotation, or inclination of the design model is corrected.

Next, the processing shifts to Step S1004, and the design corrected model creating unit 9 provides a design correction member ID for the starting point member and links the design correction member ID to the member ID of the starting point member, and based on the actual status model of the starting point member in S1003, records coordinates and a shape of the actual status model of the starting point member as design correction member coordinates and a design correction member shape in the design correction database 11.

As described above, according to the management method and the management system of the present embodiment, with respect to a shape of a starting point member, a design model is corrected in shape by using measurement data, and a shape of an actual status model reflecting an actual construction is recorded in the design correction database 11. Therefore, the actual construction status can be turned over to the next construction process.

### <Second Embodiment>

### (Configuration of Management System)

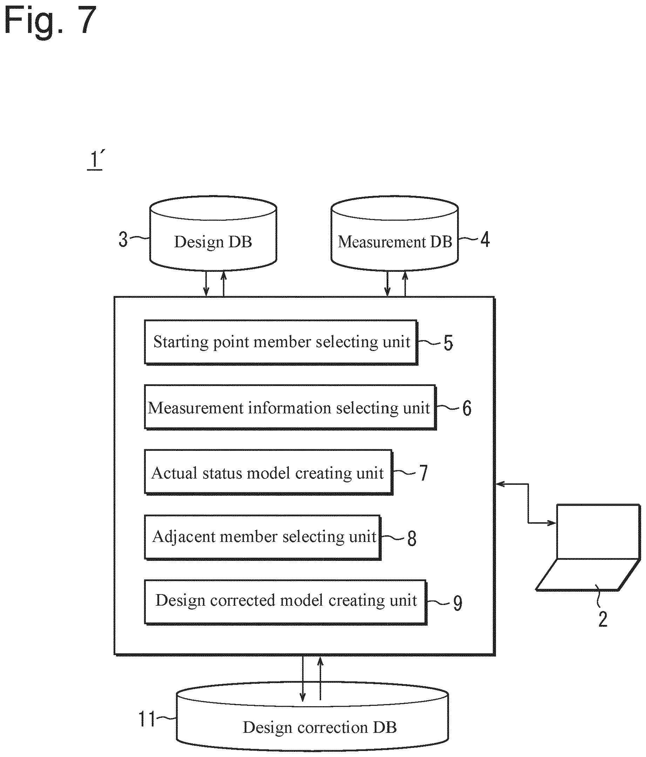

Fig. 7 is a configuration block diagram of a management system 1' according to a second embodiment of the present invention. The same configuration as in the first embodiment is provided with the same reference sign, and description thereof is omitted. The management system 1' of the present embodiment includes the input/output device 2, the design database 3, the measurement database 4, the starting point member selecting unit 5, the measurement information selecting unit 6, the actual status model creating unit 7, an adjacent member selecting unit 8, the design corrected model creating unit 9, and the design correction database 11.

The adjacent member selecting unit 8 and the design corrected model creating unit 9 are configured by electronic circuits as with other functional units. The adjacent member selecting unit 8 and the design corrected model creating unit 9 will be described in a management method according to the present embodiment to be described below.

### (Management Method)

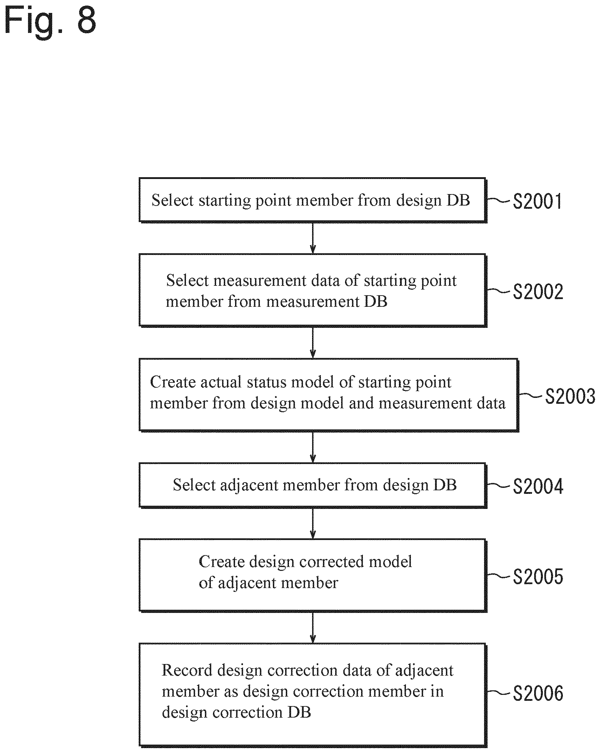

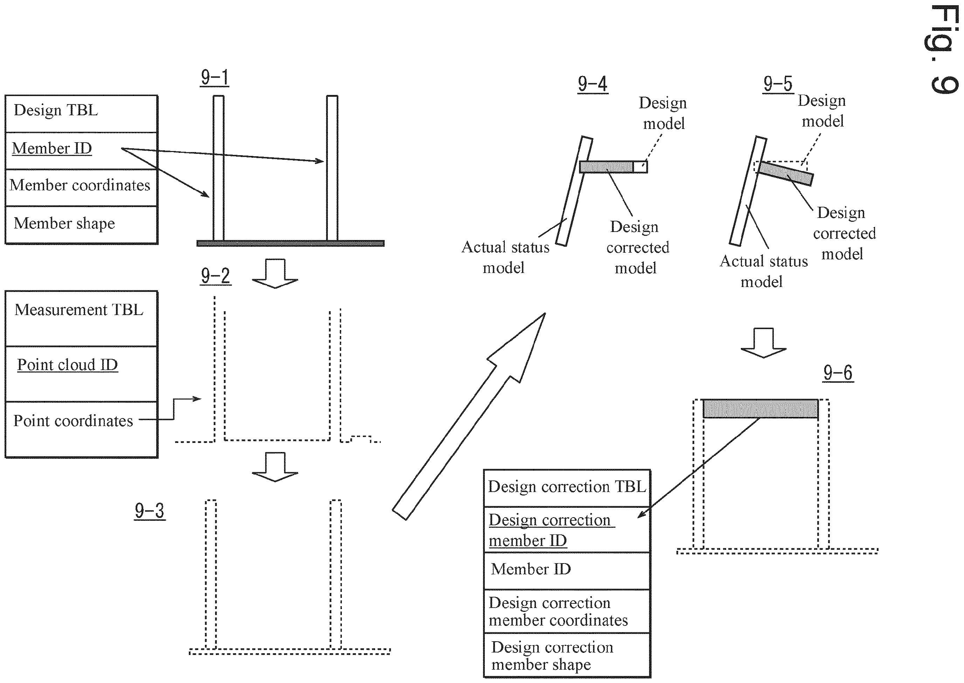

Fig. 8 is a management flowchart illustrating a management method according to the second embodiment of the present invention, and Fig. 9 is a work image view of the management flow. In the management method according to the present embodiment, an actual status model for a certain member is created, a design corrected model for a member adjacent to the certain member is created, and data management is performed to reflect an actual construction status in design of an unconstructed member. The same step as in the management method of the first embodiment is provided with the same reference sign, and description thereof is omitted.

Steps S2001 to S2003 are the same as Steps S1001 to S003. When management processing is started, a starting point member is selected by the starting point member selecting unit 5 in Step S2001 (reference sign 9-1 in Fig. 9), point cloud data of the starting point member is selected by the measurement information selecting unit 6 in S2002 (reference sign 9-2), and an actual status model of the starting point member is created by the actual status model creating unit 7 in Step S2003 (reference sign 9-3).

Next, the processing shifts to Step S2004, and the adjacent member selecting unit 8 reads the design table 31, and extracts an "adjacent member" adjacent to the starting point member based on data on coordinates and a shape of the starting point member in the design table 31, or displays design models around the starting point member on the input/output device 2 and causes an administrator to select an "adjacent member" adjacent to the starting point member.

Next, the processing shifts to Step S2005, and the design corrected model creating unit 9 creates a design corrected model of the adjacent member based on the actual status model of the starting point member created in Step S2003. Here, creation of the design corrected model of the adjacent member by the design corrected model creating unit 9 is performed, for example, as follows.
(Case 1) As indicated by the reference sign 9-4 in Fig. 9, in accordance with the shape of the actual status model of the starting point member, a model is created by correcting the shape of the design model of the adjacent member so as not to cause interference.
(Case 2) As indicated by the reference sign 9-5 in Fig. 9, in accordance with the shape of the actual status model of the starting point member, a model is created by correcting coordinates of the design model of the adjacent member so as not to cause interference.

Next, the processing shifts to Step S2006, and the design corrected model creating unit 9 provides a design correction member ID for the adjacent member, and links the design correction member ID to the member ID of the adjacent member and records coordinates and a shape of the design corrected model of the adjacent member as design correction member coordinates and a design correction member shape in the design correction database 11.

As described above, according to the management method and the management system of the present embodiment, a shape of an adjacent member is corrected by using an actual status model of a starting point member, and a design corrected model shape is recorded in the design correction database 11. Therefore, the actual construction status can be turned over to the next construction process.

### <Third Embodiment>

A management system and a management method according to the present embodiment are additionally applied to the management method according to the second embodiment. In the management system and the management method according to the present embodiment, not only a design corrected model of an adjacent member adjacent to a starting point member, but also design corrected models of a member adjacent to the adjacent member, a member adj acent to the member adj acent to the adj acent member, and a member adjacent to the member adjacent to the member adj acent to the adj acent member... are recursively created, and data management is performed to reflect the correction in design of members in the entire area to be subsequently constructed.

### (Configuration of Management System)

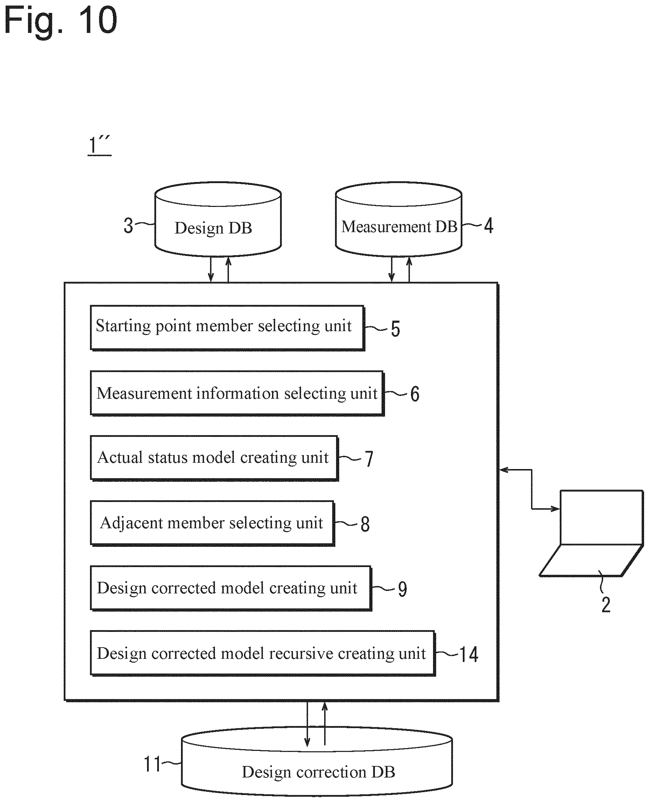

Fig. 10 is a configuration block diagram of a management system 1" according to a third embodiment of the present invention. The same configuration and process as in the second embodiment are provided with the same reference signs, and descriptions thereof are omitted. The management system 1" is configured by adding a design corrected model recursive creating unit 14 to the second embodiment.

The design corrected model recursive creating unit 14 is also configured by an electronic circuit as with other functional units. The design corrected model recursive creating unit 14 will be described in a management method according to the present embodiment to be described below.

### (Management Method)

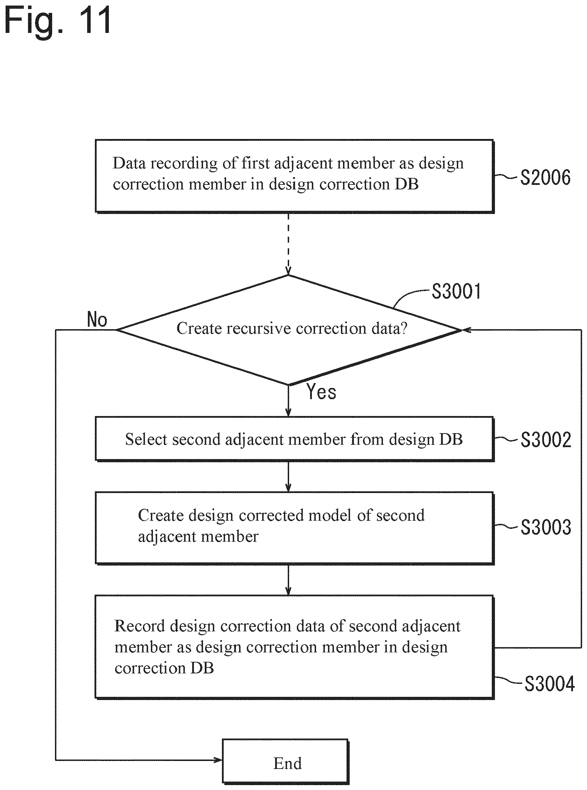

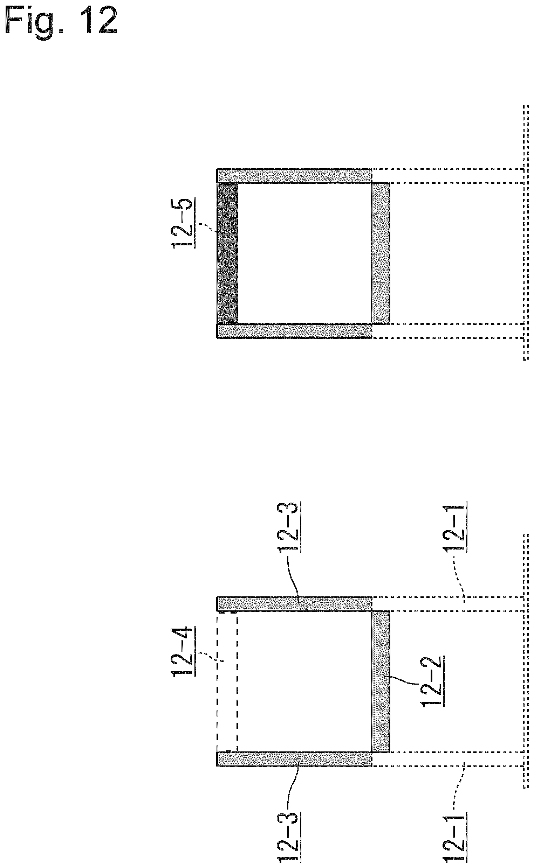

Fig. 11 is a management flowchart illustrating a management method according to the third embodiment of the present invention and Fig. 12 is a work image view of the management flow. Management processing according to the present embodiment is started after the steps S2001 to S2006 in the second embodiment are completed and corrected design data of the adj acent member is recorded in the design correction database 11. When this management processing is started, the processing shifts to Step S3001, and the design corrected model recursive creating unit 14 causes an administrator to select whether to create recursive correction data. When the administrator selects YES, the processing shifts to Step S3002. When the administrator selects NO, this management flow is ended.

When the processing shifts to Step S3002, the design corrected model recursive creating unit 14 defines the adjacent member in Step S2006 as a first adjacent member, and causes the adjacent member selecting unit 8 to select a "second adj acent member." The adj acent member selecting unit 8 extracts a "second adjacent member" adjacent to the first adjacent member based on data on the coordinates and the shape of the first adj acent member in the design table 31, or displays design models around the first adjacent member on the input/output device 2 and causes the administrator to select a "second adjacent member" adjacent to the first adjacent member.

Next, the processing shifts to Step S3003, and the design corrected model recursive creating unit 14 causes the design corrected model creating unit 9 to create a design corrected model of the second adjacent member. In accordance with the shape of the design corrected model of the first adjacent member, the design corrected model creating unit 9 creates a model by correcting the shape of the design model of the second adjacent member or creates a model by correcting coordinates of the design model of the second adjacent model so as not to cause interference.

Next, the processing shifts to Step S3004, and the design corrected model recursive creating unit 14 causes the design corrected model creating unit 9 to record design correction data of the second adjacent member. The design corrected model creating unit 9 provides a design correction member ID for the second adjacent member, and links this design correction member ID to the member ID of the second adjacent member and records data on coordinates and a shape of the design corrected model of the second adj acent member as data on design correction member coordinates and a design correction member shape in the design correction database 11. After recording, the processing returns to Step S3001, and the design corrected model recursive creating unit 14 causes the administrator to select whether to create recursive correction data of a third adjacent member. According to a request of the administrator, the design corrected model recursive creating unit 14 recursively creates design corrected models of a fourth adjacent member, a fifth adjacent member,... , and an n-th adj acent member, and when there is no more request for creation, this management flow is ended.

With reference to Fig. 12, a detailed example will be described. First, before S2006, design corrected models of a "first beam (reference sign 12-2)" and a "second iron frame (reference sign 12-3)" that are adjacent members adjacent to a "first iron frame (reference sign 12-1)" as a starting point member are created. Next, the processing shifts to Step S3002, and a "second beam" that comes into contact with an upper end of the "second iron frame" is selected as a second adjacent member (reference sign 12-4) . Next, the processing shifts to Step S3003, and based on the corrected model of the "second iron frame," a design corrected model of the "second beam" is created (reference sign 12-5) . In Step S3004, design correction data based on the design corrected model of the "second beam" is recorded in the design correction database 11.

As described above, according to the management method and the management system of the present invention, to reflect an actual construction status, design of members in the entire area to be subsequently constructed is recursively corrected, and design correction data of the members can be managed.

### <Fourth Embodiment>

A management system and a management method according to the present embodiment are additionally applied to the management method according to the second or third embodiment. In the management method according to the present embodiment, when a design model and an actual status model of a starting point member are different from each other, data on a design corrected model of an adjacent member is managed.

### (Configuration of Management System)

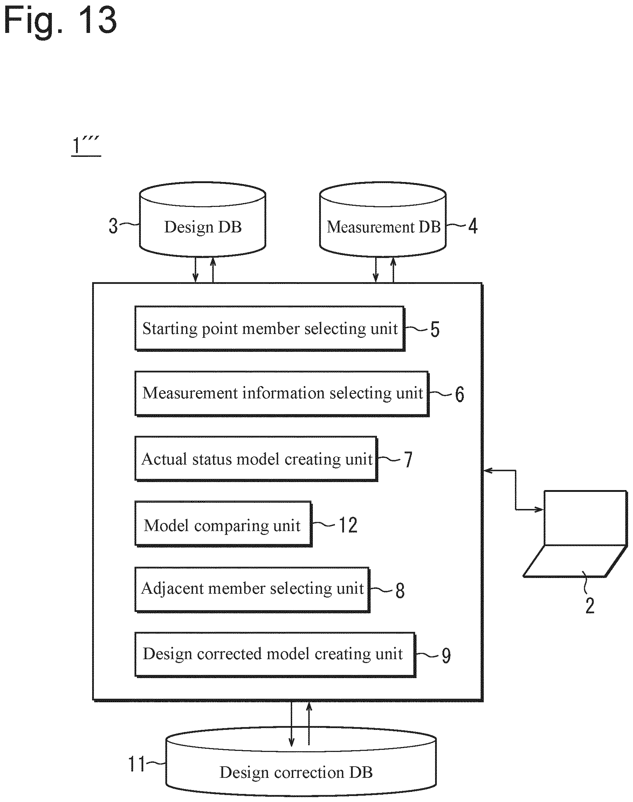

Fig. 13 is a configuration block diagram of a management system 1‴ according to a fourth embodiment of the present invention. The same configuration as in the embodiments described above is provided with the same reference sign, and description thereof is omitted. The management system 1‴ is configured by adding a model comparing unit 12 to the second embodiment.

The model comparing unit 12 is also configured by an electronic circuit as with other functional units. The model comparing unit 12 will be described in a management method according to the present embodiment to be described below.

### (Management Method)

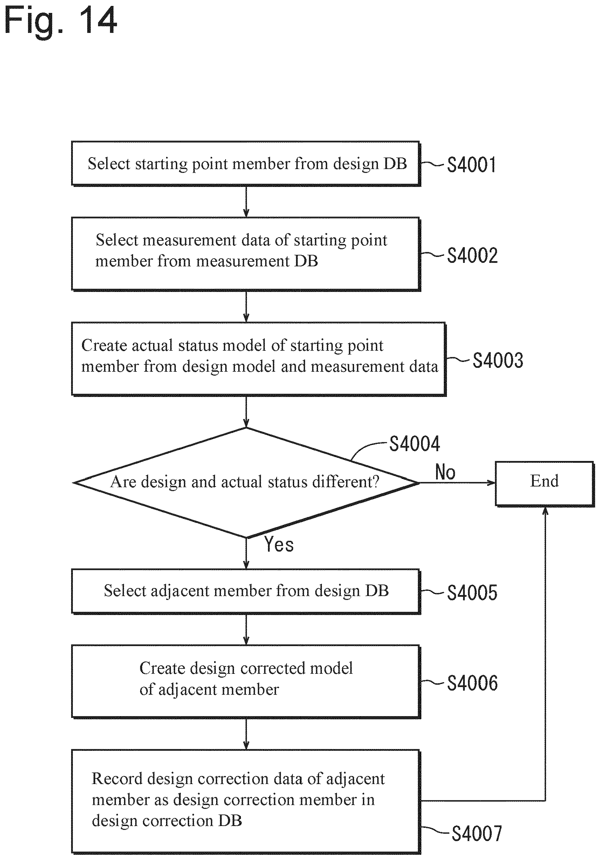

Fig. 14 is a management flowchart illustrating a management method according to the fourth embodiment of the present invention. The same step as in the embodiments described above is provided with the same reference sign, and description thereof is omitted.

Steps S4001 to S4003 are the same as Steps S1001 to S003. When management processing is started, a starting point member is selected by the starting point member selecting unit 5 in Step S4001, point cloud data of the starting point member is selected by the measurement information selecting unit 6 in S4002, and an actual status model of the starting point member is created by the actual status model creating unit 7 in Step S4003.

Next, the processing shifts to Step S4004, and the model comparing unit 12 compares a shape of the actual status model of the starting point member with a shape of the design model of the start point member. When the design and the actual status are the same, an adjacent member does not need to be corrected in design, and the original design model can be referred to for subsequent construction, so that this management flow is ended. When the design and the actual status are different, the processing shifts to Step S4005. The determination that the design and the actual status are "the same" includes not only a case where they completely match but also a case where a difference between them is within an acceptable range determined in advance in consideration of construction acceptable errors, etc. The determination that the design and the actual status are "different" means a case where the difference is beyond the acceptable range described above.

After the processing shifts to Step S4005, the processing is performed in the same manner as in Steps S2004 to S2006. That is, an adjacent member adjacent to the starting point member is selected by the adjacent member selecting unit 8 in Step S4005 in the same manner as in Step S2004, and a design corrected model of the adj acent member is created in Step S4006 in the same manner as in Step S2005. Then, in Step S4007, design correction data of the adj acent member is recorded in the design correction database 11 in the same manner as in Step S2006.

As described above, according to the management method and the management system of the present embodiment, only when the shape of the starting point member is different between the design and the actual status, the design shape of the adjacent member that is influenced by this difference is corrected and the data is managed. The present embodiment has been described in the case where it is applied to the second embodiment, however, the present embodiment is also applicable to the third embodiment.

### <Fifth Embodiment>

In a management system and a management method according to the present embodiment, by utilizing design correction data managed in the design correction database 11, data management is performed to reflect the correction in design BIM (upstream).

### (Configuration of Management System)

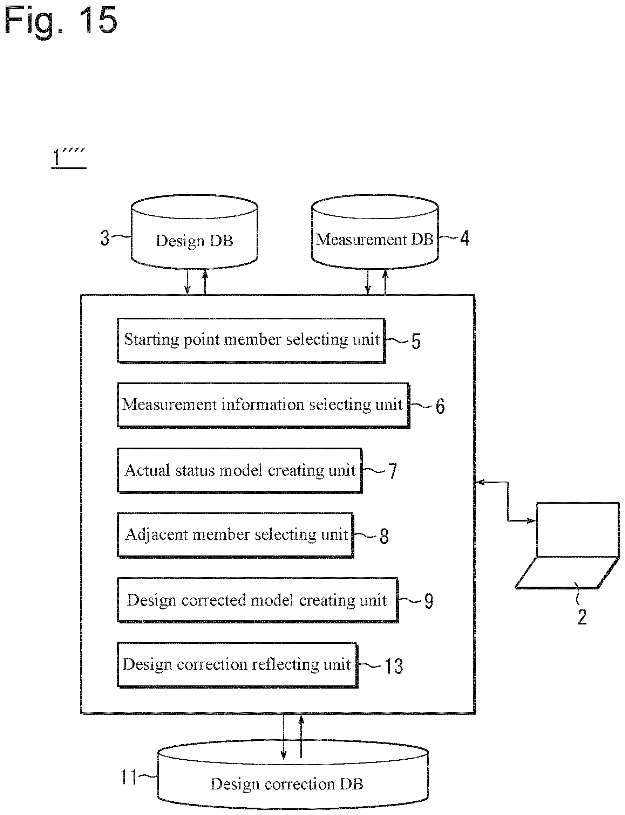

Fig. 15 is a configuration block diagram of a management system 1ʺʺ according to a fifth embodiment of the present invention. The same configuration and process as in the embodiments described above are provided with the same reference signs, and descriptions thereof are omitted. The management system 1ʺʺ is configured, as an example, by adding a design correction reflecting unit 13 to the second embodiment.

The design correction reflecting unit 13 is also configured by an electronic circuit as with other functional units. The design correction reflecting unit 13 will be described in a management method according to the present embodiment to be described below.

### (Management Method)

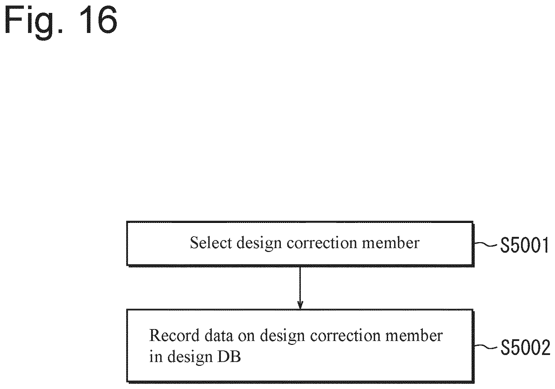

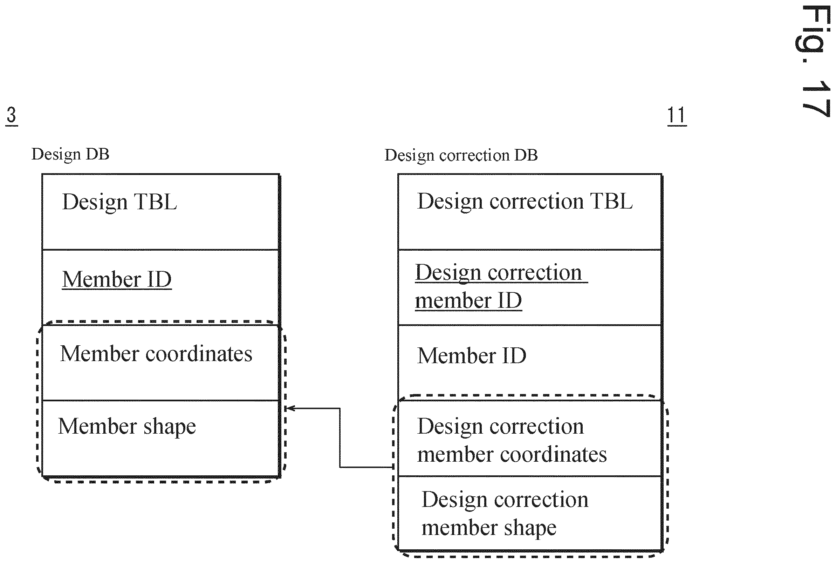

Fig. 16 is a management flowchart illustrating a management method according to the fifth embodiment of the present invention, and Fig. 17 is a work image view of the management flow. When management processing according to the present embodiment is started, the processing shifts to Step S5001, and the design correction reflecting unit 13 reads the design database 3, displays a list of member IDs or design models on the input/output device 2, and causes an administrator to select a member that the administrator desires to correct in design. The administrator selects a design correction member through the input/output device 2.

Next, the processing shifts to Step S5002, and based on the member ID of the selected member, the design correction reflecting unit 13 reads the design correction database 11 and writes data on design correction member coordinates and a design correction member shape of the design correction member over member coordinates and a member shape in the design database 3 (refer to Fig. 17). After updating the design database 3, the design correction reflecting unit 13 ends this management flow.

As described above, according to the management method and the management system of the present embodiment, design correction data of a member that needs to be corrected from the original design can be reflected in design BIM (upstream process). Therefore, at a construction site, a situation where information of design BIM to be referred to each time of the progression of processes is used while being left old in a downstream process, and an actual on-site status and the construction drawing do not match, can be prevented, and it becomes possible to efficiently utilize BIM at the construction site. The present embodiment has been described in the case where it is applied to the second embodiment, however, the present embodiment is also applicable to the first, third, and fourth embodiments.

In the first to fifth embodiments, it is described that design correction data of the "actual status model" or "design corrected model" are recorded in the design correction database 11. These design correction data can be output from the design correction database 11 to an external system, and the design correction data can be used and utilized in the external system.

Preferred embodiments and modifications of the present invention have been described above, and each embodiment and each modification can be combined based on the knowledge of a person skilled in the art, and such a combined embodiment is also included in the scope of the present invention.

### Reference Signs List

- 1, 1', 1", 1‴, 1ʺʺ: Management system
- 2: Input/output device
- 3: Design database
- 31: Design table
- 4: Measurement database
- 41: Measurement table
- 5: Starting point member selecting unit
- 6: Measurement information selecting unit
- 7: Actual status model creating unit
- 8: Adjacent member selecting unit
- 9: Design corrected model creating unit
- 11: Design correction database
- 111: Design correction table
- 12: Model comparing unit
- 13: Design correction reflecting unit
- 14: Design corrected model recursive creating unit

## Claims

1. A management method comprising: by transmitting and receiving information to and from a design database recording, with respect to members of a construction object, design data of at least member IDs, member coordinates, and member shapes, and a measurement database recording measurement data of the construction object,
a step of selecting a starting point member from the design database;
a step of selecting the measurement data corresponding to the starting point member from the measurement database; and
a step of creating, with respect to the starting point member, an actual status model by performing shape correction of a design model of the starting point member created from the design database by using the measurement data.

2. The management method according to Claim 1, further comprising:
a step of recording the starting point member as a design correction member, and coordinates and a shape of the actual status model of the starting point member as design correction member coordinates and a design correction member shape in a design correction database.

3. The management method according to Claim 1, further comprising:
a step of selecting an adjacent member adjacent to the starting point member from the design database;
a step of creating a design corrected model by performing shape correction of a design model of the adjacent member in accordance with a shape of the actual status model of the starting point member; and
a step of recording coordinates and a shape of the design corrected model of the adjacent member as design correction member coordinates and a design correction member shape in a design correction database.

4. The management method according to Claim 3, further comprising:
a step (A) of selecting, by defining the adjacent member as a first adjacent member, a second adjacent member adjacent to the first adjacent member from the design database;
a step (B) of creating a design corrected model by performing shape correction of a design model of the second adjacent member in accordance with the shape of the design corrected model of the first adjacent member;
a step (C) of recording coordinates and a shape of the design corrected model of the second adjacent member as design correction member coordinates and a design correction member shape in the design correction database; and
a step (D) of creating and recording design corrected models of a third adjacent member, a fourth adjacent member, ..., and an n-th adjacent member by repeating the steps (A) to (C) according to a request of an administrator.

5. The management method according to Claim 3, wherein
with respect to the starting point member, the design model and the actual status model are compared, and when the design and the actual status are different from each other, the step of selecting the adjacent member is started.

6. The management method according to any one of Claims 2 to 5, further comprising:
a step of writing the design correction member coordinates and the design correction member shape of the design correction member recorded in the design correction database over member coordinates and a member shape linked by the member ID in the design database.

7. A management system comprising:
a design database recording, with respect to members of a construction object, design data of at least member IDs, member coordinates, member shapes;
a measurement database recording measurement data of the construction object;
a starting point member selecting unit configured to select a starting point member from the design database;
a measurement information selecting unit configured to select the measurement data corresponding to the starting point member from the measurement database; and
an actual status model creating unit configured to create an actual status model with respect to the starting point member by performing shape correction of a design model of the starting point member created from the design database by using the measurement data.

8. The management system according to Claim 7, further comprising:
a design corrected model creating unit configured to record the starting point member as a design correction member, and coordinates and a shape of the actual status model of the starting point member as design correction member coordinates and a design correction member shape in a design correction database.

9. The management system according to Claim 7, further comprising:
an adjacent member selecting unit configured to select an adjacent member adjacent to the starting point member from the design database; and
a design corrected model creating unit configured to create a design corrected model by performing shape correction of a design model of the adjacent member in accordance with a shape of the actual status model of the starting point member, and record coordinates and a shape of the design corrected model of the adjacent member as design correction member coordinates and a design correction member shape in a design correction database.

10. The management system according to Claim 9, further comprising:
a design corrected model recursive creating unit configured to select, by defining the adj acent member as a first adjacent member, a second adjacent member adjacent to the first adjacent member from the design database, create a design corrected model by performing shape correction of a design model of the second adjacent member in accordance with the shape of the design corrected model of the first adjacent member, record coordinates and a shape of the design corrected model of the second adjacent member as design correction member coordinates and a design correction member shape in the design correction database, and repeatedly create and record design corrected models of a third adjacent member, a fourth adjacent member, ..., and an n-th adjacent member according to a request of an administrator.

11. The management system according to Claim 9, further comprising:
a model comparing unit configured to compare the design model and the actual status model with respect to the starting point member, wherein
when the model comparing unit determines that the design and the actual status are different from each other, the adjacent member selecting unit functions.

12. The management system according to any one of Claims 8 to 11, further comprising:
a design correction reflecting unit configured to write design correction member coordinates and a design correction member shape of the design correction member recorded in the design correction database over member coordinates and a member shape linked by the member ID in the design database.

13. A management program describing the management method according to any one of Claims 1 to 6 as a computer program and enabling execution of the management method.
